# FASCICULE DE BREVET EUROPEEN

(11) **EP 0 282 403 B1**
(45) Date de publication et mention de la délivrance du brevet: **26.05.1993**
(21) Numéro de dépôt: 88400509.1
(22) Date de dépôt: 03.03.1988
(51) Int. Cl.: C30B 7/00, C30B 29/58

(54) **Système de cristallogénèse, notamment pour vaisseau spatial**
Kristallzüchtungsapparatur, insbesondere für Raumschiffe
Crystal-growth system, especially for space vessels

(30) Priorité: 04.03.1987 FR 8702947
(43) Date de publication de la demande: 14.09.1988
(73) Titulaire: AEROSPATIALE Société Nationale Industrielle, 75781 Paris Cédex 16 (FR)
(72) Inventeur: Martin, Gérard Michel, F-59300 Valenciennes (FR); Auffret, Jean-Claude, F-78130 Chapet (FR); Delarue, Jean-Jacques, F-78140 Velizy Villacoublay (FR); Claramonte, Manuel Pierre, F-92370 Chaville (FR); Bonnet, Guy Michel, F-78300 Poissy (FR)
(74) Mandataire: Bonnetat, Christian

(56) Documents cités:
- EP-A- 265 319
- US-A- 3 788 818
- JOURNAL OF CRYSTAL GROWTH, vol. 76, no. 3, 11 août 1986, pages 663-672, Elsevier Science Publishers B.V. (North-Holland Physics Publishing Division), Amsterdam, NL; W. LITTKE et al.: "Protein single crystal growth under microgravity"
- A.I.A.A. JOURNAL, vol. 16, no. 5, mai 1978, pages 458-462, New York, US; M.D. LIND: "Crystal growth from solutions in low gravity"

## Description

La présente invention concerne un système de cristallogénèse, spécialement mais non limitativement destiné à être mis en oeuvre à bord d'un vaisseau spatial.

On sait que l'une des méthodes d'étude des substances macromoléculaires consiste à former des cristaux desdites substances et à soumettre lesdits cristaux à des examens, notamment spectrographiques. Pour former de tels cristaux, on utilise des méthodes de diffusion, éventuellement à travers une paroi poreuse de diffusion. A cet effet, dans une enceinte, on dispose un creuset rempli d'un mélange liquide d'une substance macromoléculaire à étudier et d'un agent précipitant en concentration insuffisante pour agir, puis on introduit dans ladite enceinte un tel agent précipitant, soit sous forme vapeur, soit sous forme liquide.

Par diffusion, la concentration du mélange de l'agent précipitant et de la substance macromoléculaire contenu dans le creuse tend à s'aligner sur celle de l'agent précipitant contenu dans l'encenite. Par suite, en faisant varier la concentration de ce dernier agent précipitant, on peut agir sur la cristallisation de ladite substance macromoléculaire. Généralement, le creuset et l'enceinte sont au moins partiellement transparents, de sorte qu'un opérateur peut suivre visuellement le développement ce la cristallisation.

Toutefois, les cristaux obtenus dans es laboratoires terrestres par la mise en oeuvre de ces techniques de diffusion ne sont pas parfaits, tant en qualité qu'en taille, notamment à cause des phénomènes de convexion dus à la pesanteur.

Pour remédier à cet inconvénient, il est avantageux de pouvoir mettre en oeuvre de telles techniques de diffusion à bord de vaisseaux spatiaux, car alors les conditions d'apesanteur éliminent ces phénomènes de convexion.

Cependant, la mise en oeuvre telles quelles des méthodes terrestres se heurte à des difficultés, sinon des impossibilités, dues notamment aux conditions de travail à bord des vaisseaux spatiaux et aux conditions de lancement de ceux-ci, ainsi qu'à la faible durée de vie de certaines substances macromoléculaires (une quinzaine de jours pour les protéines par exemple). Par exemple, compte tenu des impératifs et des délais de préparation relativement longs du lancement d'un vaisseau spatial, les substances macromoléculaires seraient mortes avant que leur cristallisation dans l'espace puisse être tentée.

Le document EP-A-265 319 décrit un système de cristallogénèse permettant d'adapter les méthodes de diffusion à une utilisation à bord d'un vaisseau spatial, étant entendu que ce système pourrait cependant être utilise dans un laboratoire terrestre. Ce système de cristallogénèse par diffusion connu, notamment destiné à être mis en oeuvre à bord d'un vaisseau spatial, dans lequel une substance à cristalliser est mise en présence d'un agent précipitant comporte :
- au moins une capsule enfermant au moins un creuset et remplie d'agent précipitant, ledit creuset contenant ladite substance à cristalliser, et
- au moins un réceptacle en communication avec des moyens d'amenée d'agent précipitant et des moyens d'évacuation d'agent précipitant.

La présente invention a pour objet de perfectionner ce système, afin d'en rendre l'usage plus pratique et plus fiable.

A cette fin, selon l'invention, le système du type décrit ci-dessus est caractérisé en ce que ladite capsule est étanche, et en ce que sont prévus des moyens de connexion permettant automatiquement de relier de manière étanche et directe l'intérieur de ladite capsule avec lesdits moyens d'amenée et avec lesdits moyens d'évacuation d'agent précipitant lors de l'introduction de ladite capsule étanche dans ledit réceptacle.

On voit que ledit réceptacle, lesdits moyens d'amenée d'agent précipitant et lesdits moyens d'évacuation d'agent précipitant peuvent former un sous-ensemble fixe qui contient les produits sans contraintes de péremption trop importantes et qui peut être installé et mis en place dans une station spatiale, voire même dans le véhicule de transport pour la mise en orbite, plusieurs semaines avant le début des expériences de cristallisation. En revanche, la ou les capsules étanches, de préférence modulaires, sont manipulables aisément et peuvent, après avoir été préparées en laboratoire, être embarquées au dernier moment par les astronautes et, de plus, rapportées par ceux-ci après l'expérience.

Ainsi, grâce à l'invention, on peut obtenir un délai minimal entre la fabrication des macromolécules à étudier et le début des expériences de cristallisation en apesanteur. De plus, l'invention permet par là même de réduire les coûts du transport des vols aussi bien à l'aller qu'au retour, coûts qui sont liés au volume et à la masse emportés à chaque fois. Grâce au fait que la capsule étanche est remplie d'agent précipitant, on évite tout risque de contamination de la substance à cristalliser avant mise en place de ladite capsule dans ledit réceptacle, c'est-à-dire avant le début de la cristallisation. Cet agent précipitant remplissant la capsule avant le début de l'expérience de cristallisation doit présenter une concentration suffisamment faible pour être inerte vis-à-vis de la substance à cristalliser, afin de ne pas déclencher un commencement de cristallisation. Toutefois, grâce à une autre particularité de l'invention décrite ci-après, dans certains cas où cela est nécessaire, ledit agent précipiant initialement introduit dans la capsule peut présenter une concentration qui le rendrait actif.

Dans un mode avantageux de réalisation, lesdits moyens de connexion prévus pour automatiquement relier l'intérieur de la capsule avec les moyens d'amenée et d'évacuation comportent, d'une part, des aiguilles liées audit réceptacle et, d'autre part, des blocs de matière susceptible d'être perforée de manière étanche par lesdites aiguilles, lesdits blocs étant liés à ladite capsule. De tels blocs, par exemple réalisés en un polymère présentant d'importantes propriétés d'élasticité, sont généralement connus dans les techniques médicales, pharmaceutiques ou biologiques sous le nom de septum. Grâce à de tels moyens de connexion, on voit que ladite capsule s'enfiche, par ses septums, sur les aiguilles du réceptacle. Lorsque cet enfichage est réalisé, il suffit d'agir sur les moyens d'amenée d'agent précipitant pour introduire dans ladite capsule un agent précipitant de concentration désirée, ce qui modifie la concentration de l'agent précipitant initialement présent dans la capsule et permet le déclenchement de la cristallisation. Par contrôle de la quantité et/ou de la concentration de l'agent précipitant ainsi introduit, on a la possibilité d'agir sur la cristallisation de la substance contenue dans le creuset. De plus, grâce à cet enfichage, du liquide précipitant antérieurement présent dans la capsule peut être évacué par lesdits moyens d'évacuation sous la pression du liquide précipitant introduit par lesdits moyens d'amenée. Ainsi, bien que la capsule ait un volume constant et qu'elle soit initialement pleine, on peut introduire de l'agent précipitant frais, l'agent précipitant frais introduit chassant une quantité égale d'agent précipitant de la capsule. Pour recueillir l'agent précipitant chassé de la capsule, lesdits moyens d'évacuation comportent un vase d'expansion.

De préférence, lesdits moyens d'amenée d'agent précipitant comportent au moins une seringue. Cette seringue sert ainsi à la fois de réservoir d'agent précipitant et de moyen d'injection de celui-ci dans la capsule. Une telle seringue peut être de tout type connu et l'actionnement de son piston peut être manuel ou bien motorisé. Quelle que soit la nature des moyens d'actionnement, il est toutefois important que ceux-ci permettent de connaître la quantité d'agent précipitant injectée. De préférence, on prévoit plusieurs seringues contenant de l'agent précipitant à des concentrations différentes. Ainsi, le contrôle de la cristallisation de la substance contenue dans le creuset en est facilité.

Avantageusement, le système selon l'invention comporte un bouchon pouvant être introduit dans ledit réceptacle à la place de ladite capsule, ledit bouchon comportant un corps spongieux imbibé d'agent précipitant et accessible auxdites aiguilles desdits moyens de connexion à travers des blocs (septums) solidaires dudit bouchon et réalisés en une matière susceptible d'être perforée de manière étanche par lesdites aiguilles. Un tel bouchon est mis en place dans le réceptacle à la place de ladite capsule avant l'enfichage de celle-ci, et éventuellement après la sortie de ladite capsule dudit réceptacle, notamment pendant les phases de transport, de sorte que les aiguilles peuvent constamment être baignées par de l'agent précipitant, ce qui leur évite tout risque de contamination et d'obstruction.

Notamment dans le cas où l'on utilise plusieurs seringues contenant respectivement de l'agent précipitant à des concentrations différentes, il est avantageux de prévoir des clapets anti-retour dans lesdits moyens d'amenée. On isole ainsi chaque circuit d'amenée par rapport aux autres et on évite les mélanges non désirés d'agent précipitant de concentrations différentes. Ces clapets anti-retour sont alors disposés aussi près que possible desdites aiguilles.

On sait que les techniques de diffusion utilisées en cristallogénèse sont variées en ce qui concerne le processus de diffusion. L'un des objets de la présente invention est de concevoir une capsule qui soit apte, sans aucune modification ou tout au moins avec un minimum de modifications, à être utilisée quel que soit le processus de diffusion mis en oeuvre (dialyse, diffusion liquide/liquide et diffusion liquide/vapeur).

Ainsi, les utilisateurs du système selon l'invention bénéficient d'une grande souplesse d'expérimentation et les coûts de matériel et d'expérience sont réduits.

A cette fin, il est avantageux qu'un obturateur commandable, manuellement ou par l'intermédiaire de moyens moteurs, soit prévu à l'intérieur de ladite capsule, afin soit d'obturer ledit creuset pour isoler son contenu de la cavité intérieure de ladite capsule, soit de dégager ledit creuset pour mettre son contenu en communication avec cette dernière cavité. Ainsi, lorsque cela est nécessaire pour certaines fins expérimentales, il est possible de remplir ladite capsule d'agent précipitant à une concentration très voisine de la concentration théorique de formation des cristaux, sans pour cela amorcer de façon prématurée la cristallogénèse, puisqu'alors l'obturateur peut isoler le creuset de la capsule. Lorsque l'expérience doit commencer, il suffit alors de faire passer ledit obturateur, directement associé au cresuset, de sa position d'obturation à sa position de dégagement.

Dans un mode de réalisation avantageux, ledit obturateur commandable est un disque ajouré monté rotatif autour d'un arbre accessible de l'extérieur de ladit capsule. La rotation dudit disque peut être obtenue manuellement ou par l'action de moyens moteurs. Quel que soit le mode d'actionnement du disque, on voit que ledit creuset est obturé lorsqu'il se trouve en regard d'une partie pleine du disque et au contraire dégagé, lorsqu'il se trouve en regard d'un orifice de celui-ci.

En position d'obturation du cresuset par le disque, celui-ci s'applique sur les bords l'ouverture dudit creuset. Pour éviter que, dans son mouvement, le disque ne détériore par frottement, l'éventuelle membrane (nécessaire en diffusion par dialyse) recouvrant le cresuset, il est avantageux que ledit arbre du disque rotatif puisse coulisser de façon limitée, parallèlement à son axe, de façon que ledit disque soit écarté du creuset pendant le passage du disque d'une position d'obturation à une position de dégagement et vice-versa.

Pour éliminer encore plus le risque de détérioration de l'éventuelle membrane de dialyse recouvrant le creuset, on prévoit qu'au moins la partie de l'obturateur entrant en contact avec le creuset dans une position d'obturation est constituée par une membrane souple.

De préférence, une paroi de séparation est prévue à l'intérieur de ladite capsule, entre lesdits moyens de connexion correspondant auxdits moyens d'amenée d'agent précipitant et lesdits moyens de connexion correspondant auxdits moyens d'évacuation d'agent précipitant.

De plus, dans le cas d'un processus de dialyse ou de diffusion liquide/liquide, une surface de diffusion peut être prévue, à l'intérieur de ladite capsule, entre, d'une part, lesdits moyens de connexion auxdits moyens d'amenée et d'évacuation d'agent précipitant et, d'autre part, ledit creuset.

Dans le cas d'une diffusion liquide/vapeur, un élément de rétention d'agent précipitant est avantageusement prévu, à l'intérieur de ladite capsule, entre, d'une part, lesdits moyens de connexion auxdits moyens d'amenée et d'évacuation d'agent précipitant et, d'autre part, ledit creuset. De préférence, un obturateur commandable supplémentaire est alors associé audit élément de rétention ; il peut être lié en rotation à l'obturateur commandable associé directement au creuset.

Il est préférable qu'un chambre intermédiaire soit ménagée, dans la capsule, entre d'une part, l'obturateur commandable associé directement au creuset, et, d'autre part, suivant le cas, la surface de diffusion ou l'élément de rétention (ou l'obturateur commandable supplémentaire).

Les figures du dessin annexé feront bien comprendre comment l'invention peut être réalisée. Sur ces figures, des références identiques désignent des éléments semblables.

La figure 1 illustre, de façon simplifiée et schématique, un système selon l'invention avant, et éventuellement après, une expérience de cristallogénèse.

La figure 2 illustre, de façon semblable à celle de la figure 1, ledit système pendant une expérience de cristallogénèse.

La figure 3 montre, en coupe axiale, un mode de réalisation avantageux pour une capsule destinée à la cristallogénèse par dialyse.

La figure 4 est une coupe transversale, à échelle réduite, suivant la ligne IV-IV, respectivement des figures 3,8 et 9.

La figure 5 est une coupe transversale, à échelle réduite, suivant la ligne V-V, respectivement des figures 3 et 8.

La figure 6 est une vue partielle suivant le flèche F de la figure 3.

La figure 7 illustre une variante de réalisation des moyens d'actionnement du disque obturateur.

La figure 8 montre, en coupe axiale, un mode de réalisation avantageux pour une capsule destinée à la diffusion en phase liquide.

La figure 9 montre, en coupe axiale, un mode de réalisation avantageux pour une capsule destinée à la diffusion en phase vapeur.

La figure 10 est une coupe transversale, à échelle réduite, suivant la ligne X-X de la figure 9.

La figure 11 est une coupe transversale partielle, à échelle réduite, suivant la ligne XI-XI de la figure 9.

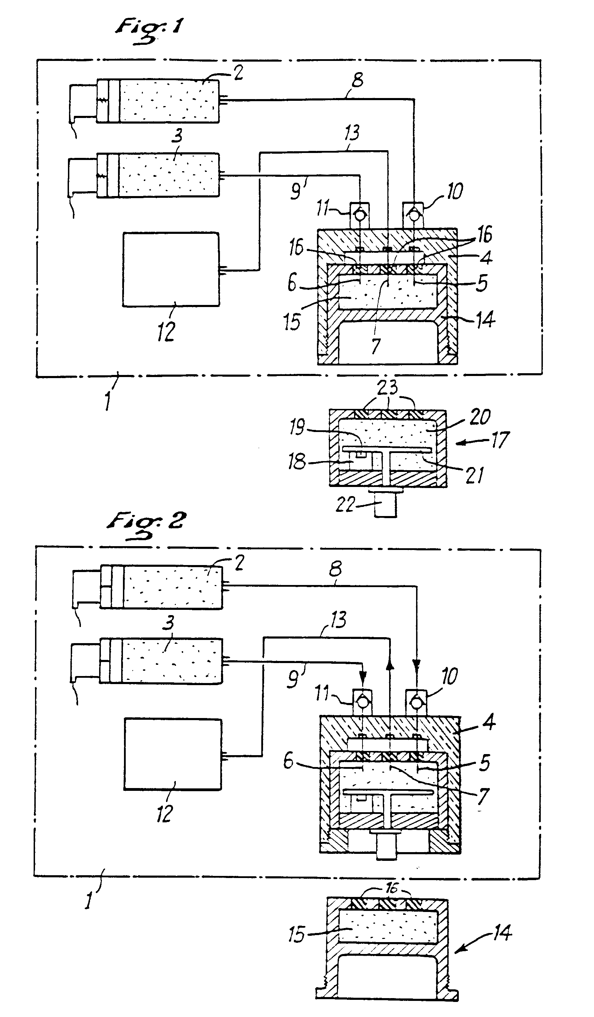

Sur les figures 1 et 2, on a indiqué schématiquement par un rectangle en trait mixte, un caisson thermostaté 1 mécaniquement solidaire, par exemple, de la structure d'une station spatiale. Ce caisson thermostaté 1 ne fait pas partie du cadre de la présente invention et peut être réalisé de toute façon connue.

A l'intérieur du caisson thermostaté 1 sont montés :
- des seringues 2 et 3 contenant un agent précipitant à des concentrations différentes :
- un réceptacle 4, par exemple en forme de boîte ouverte, et dans le fond duquel sont prévues des aiguilles 5,6 et 7;
- des canalisations 8 et 9 reliant respectivement la sortie des seringues 2 et 3 aux aiguilles 5 et 6, par l'intermédiaire de clapets anti-retour 10 et 11 ;
- un vase d'expansion ou de trop-plein 12 relié à l'aiguille 7 par l'intermédiaire d'une canalisation 13 ;
- un bouchon 14 pour le réceptacle 4, comportant un corps spongieux 15 qui est imbibé d'agent précipitant et dans lequel pénètre lesdites aiguilles 5,6 et 7 lorsque ledit bouchon 14 est en position d'obturation dudit réceptacle. A cet effet, le fond du bouchon 14 comporte des blocs 16, en une matière pouvant être perforée de façon étanche par lesdites aiguilles 5,6 et 7, qui peuvent ainsi atteindre le corps spongieux 15.

Par ailleurs, le système selon l'invention montré par les figures 1 et 2 comporte une capsule étanche 17 enfermant au moins un creuset 18, dans la cavité 19 duquel peut être introduit un mélange d'une substance macromoléculaire à cristalliser et d'agent précipitant à une concentration inactive. La cavité intérieure 20 de la capsule étanche 17 est remplie d'agent précipitant. La cavité 19 du creuset 18 peut être isolée, ou au contraire mise au contact, de l'agent précipitant contenue dans la cavité 20 de la capsule 17, grâce à un obturateur mobile 21, mû par un organe d'actionnement 22. Une paroi de la capsule étanche 17 comporte des blocs 23, semblables aux blocs 16 du bouchon 14, réalisés en une matière susceptible d'être perforée de manière étanche par des aiguilles.

Les formes extérieures du bouchon 14 et de la capsule étanche 17 sont telles qu'ils sont interchangeables à l'intérieur du réceptacle 4.

Lorsque, comme cela est montré sur la figure 1, le bouchon 14 est en place à l'intérieur du réceptacle 4, la capsule 17 est physiquement indépendante de l'ensemble constitué des éléments 2 à 16. Il est donc possible de monter dans une station spatiale ledit ensemble 2 à 16, qui ne contient que des substances à durée de vie relativement longue, longtemps avant de charger, au lieu de sa fabrication, la substance macromoléculaire à cristalliser dans le creuset 18. Ainsi, tous les préparatifs des expériences de cristallisation, autres que ceux concernant la substance à cristalliser, peuvent être terminés, ou en cours d'achèvement, lorsque la capsule 17 est rapprochée physiquement de l'ensemble 2 à 16, en vue d'une expérience de cristallisation.

Lorsque les conditions de cette expérience sont réunies, on ôte le bouchon 14 du réceptacle 4 et on le remplace par la capsule 17 (voir la figure 2). Alors, les aiguilles 5,6 et 7 traversent les blocs 23 et débouchent donc dans la cavité intérieure 20 de la capsule 17. En agissant sur les seringues 2 et 3 (manuellement ou par l'intermédiaire d'un moteur), on injecte dans cette cavité 20 des quantités connus d'agent précipitant à des concentrations différentes de celle qui préexistait dans la capsule 17. On modifie donc la concentration de l'agent précipitant initialement contenu dans la capsule 17 et, si l'obturateur 21 est dégagé, on agit sur la cristallisation de la substance macromoléculaire contenue dans la cavité 19 du creuset 18. L'excédent d'agent précipitant injecté dans la capsule 17 est évacué par la canalisation 13 vers le vase de trop-plein 12.

Enfin, lorsque l'expérience de cristallisation est terminée, la capsule 17 est sortie du réceptacle 4 et remplacée par le bouchon 14 (figure 1). La capsule 17 peut alors être amenée en tout lieu désiré pour l'étude des cristaux obtenus.

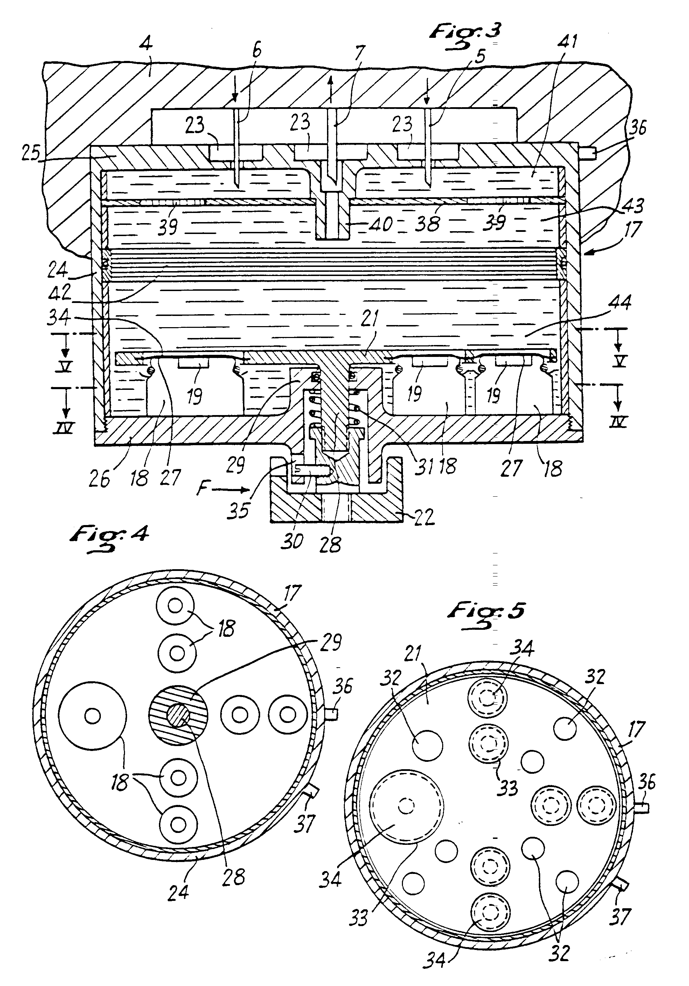

Sur les figures 3,4 et 5, on a représenté un mode de réalisation avantageux pour une capsule 17, plus particulièrement destinée à la cristallogénèse par dialyse. Cette capsule 17 comporte un corps 24, par exemple cylindrique, obturé par un fond 25, dans lequel sont prévus les blocs élastiques 23, et par un fond 26 portant une pluralité de creusets 18. Chacun desdits creusets 18 est obturé par une membrane de dialyse 27.

Le disque rotatif d'obturation 21 est solidaire d'un arbre 28 pouvant tourner et coulisser dans un palier 29, solidaire du fond 26. De plus, l'arbre 28 porte un ergot 30, appliqué par un ressort 31, disposé entre ledit fond 26 et ledit disque 21, contre une rampe 35 solidaire du fond 26.

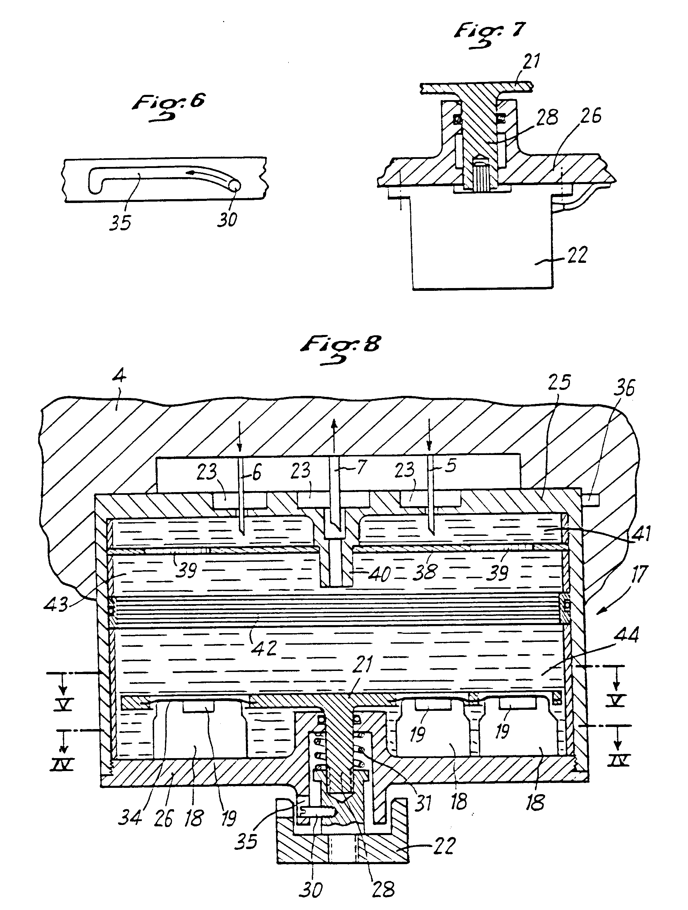

Le disque d'obturation 21 est pourvu d'une pluralité d'orifices 32 ouverts et d'une pluralité d'orifices 33, obturés par une membrane souple 34. Le nombre et la disposition des orifices 32 et 33 sont tels que, pour une première position angulaire du disque 21, tous les orifices 32 se trouvent en regard des ouvertures 19 des tous les creusets 18, et que, pour une seconde position angulaire du disque 21, toutes les membranes 34 sont en apui contre les bords des cavités 19 et contre toutes les membranes de dialyse 27 de tous les creusets 18 (position représentée sur la figure 5).

Pour passer de l'une de ces positions à l'autre, il suffit de faire tourner l'arbre 28, soit manuellement (figure 3), soit à l'aide d'un moteur (figure 7). Au cours de la rotation, grâce à la coopération de l'ergot 30 et de la rampe 35 sous l'action du ressort 31, le disque 21 est soulevé, ce qui évite la détérioration pra frottement des membranes de dialyse 27.

Le corps 24 de la capsule 17 comporte un ergot d'indexage 36 permettant, par coopération avec un élément complémentaire (non représenté) du réceptacle 4, d'amener les blocs élastiques 23 en regard des aiguilles 5,6 et 7. De plus, dans le cas où le réceptacle 4 doit recevoir une capsule spécifique 17, on peut prévoir au moins un ergot de détrompage 37.

A l'intérieur de la capsule 17, est disposée une paroi transversale 38, percée de trous 39 et traversée par un élément tubulaire 40 prolongeant l'aiguille 7. Cette paroi transversale 38 délimite dans la capsule 17, entre elle-même et le fond 25, une chambre 41 dans laquelle est injecté l'agent précipitant provenant des seringues 2 et 3, à travers les aiguilles 5 et 6.

Par ailleurs, entre l'extrémité de l'élément tubulaire 40 et le disque obturateur 21 est prévue une grille de diffusion transversale 42, partageant l'espace intérieur restant de la capsule 17, entre une chambre de mélange 43 (entre la paroi 38 et ladite grille 42) et une chambre intermédiaire 44 (entre le disque obturateur 21 et ladite grille 42). La grille de diffusion 42 a pour objet de réaliser un large de front de diffusion uniforme sur tous les creusets 18.

Ainsi, dans la chambre d'injection 41 se réalise un prémélange d'agent précipitant, ledit mélange étant parachevé dans la chambre 43. La paroi de séparation 38, associée à élément tubulaire 40, a pour objet d'augmenter la distance que doit parcourir l'agent précipitant avant de parvenir à l'aiguille d'évacuation 7, afin d'interdire d'évacuer, vers le vase de trop-plein 12, l'agent précipitant que l'on est en train d'injecter par les aiguilles 5 ou 6. Dans la chambre intermédiaire 44, le phénomène transitoire de modification de concentration se présente sous la forme d'un front de diffusion uniforme.

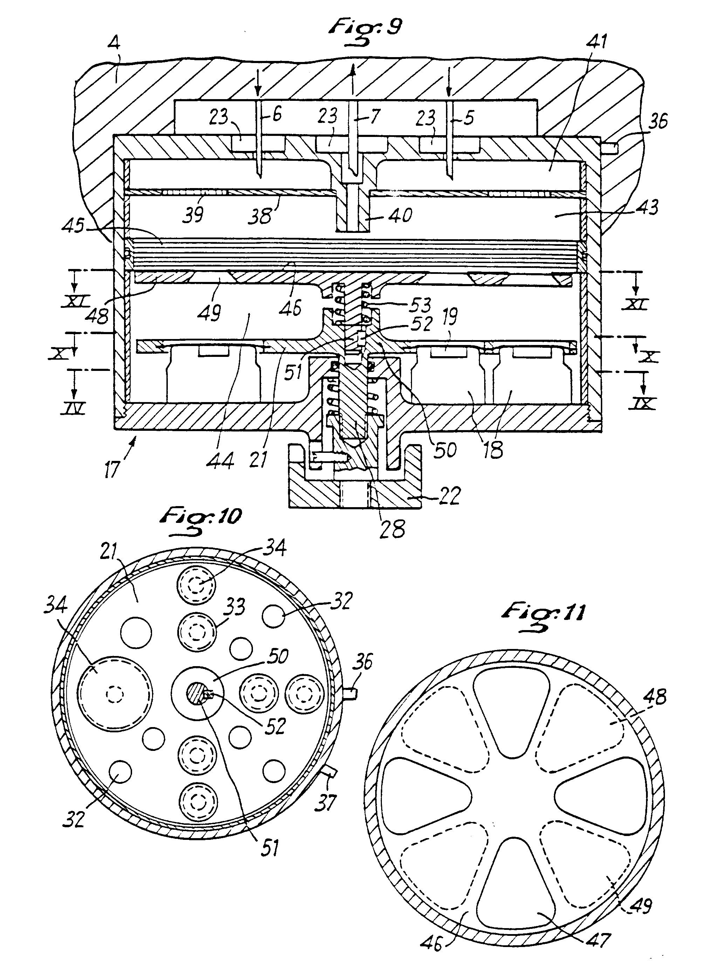

Sur la figure 8, on a représenté une capsule 17 plus particulièrement destinée à la diffusion en phase liquide/liquide. La seule différence de ce mode de réalisation avec celui des figures 3 à 7 réside en ce que les creusets 18 ne sont plus obturés par des membranes de diffusion 27.

Le mode de réalisation de la capsule 17 selon l'invention, représenté sur les figures 9,10 et 11, est plus spécialement destiné à la mise en oeuvre de cristallogénèse par diffusion liquide/vapeur. Pour l'essentiel, ce mode de réalisation est semblable à celui illustré sur la figure 8 pour une diffusion liquide/liquide. Toutefois, dans ce cas, la chambre intermédiaire 44 agencée au-dessus du disque obturateur 21 est remplie d'un gaz. Aussi, dans le mode de réalisation des figures 9 à 11, la grille de diffusion 42 des figures 3 et 8 est remplacée par un élément de rétention 45 pour l'agent précipitant liquide. Cet élément de rétention 45 est par exemple un corps spongieux.

De plus, pour commander le remplissage de la chambre intermédiaire 44 en vapeur d'agent précipitant, on prévoit un système obturateur supplémentaire (voir également la figure 11). Ce système obturateur supplémentaire comporte par exemple une plaque fixe transversale 46, pourvue d'ouvertures 47 et supportant l'élément de rétention 45, ainsi qu'un disque rotatif 48 percé d'ouvertures 49. Le disque rotatif 48 est appliqué contre la plaque fixe transversale 46, du côté opposé à l'élément de rétention 45, et, par rotation dudit disque 48, les ouvertures 49 de celui-ci peuvent être amenées, soit en coincidence avec les ouvertures 47 de la plaque 46, soit dans une position pour laquelle lesdites ouvertures 47 sont obturées par la partie non ajourée du disque 48 (position d'obturation représentée sur la figure 11).

De préférence, la commande en rotation du disque d'obturation 48 est couplée avec celle du disque obturateur 21. Pour ce faire, le disque 21 peut comporter un logement 50 pour l'arbre 51 du disque 48, ledit arbre 51 étant lié en rotation au disque obturateur 21 par une clavette 52. Un ressort 53 peut être prévu, d'une part, pour plaquer élastiquement le disque rotatif 48 contre la plaque fixe 46 et, d'autre part, pour désaccoupler les disques 21 et 48, lors du mouvement d'écartement et le rapprochement du disque 21 par rapport aux creusets 18.

Les figures 3 à 11 montrent que, quel que soit le processus de diffusion mis en oeuvre, les capsules utilisées présentent des structures semblables. Ces structures sont telles que, entre les aiguilles d'injection 5 et 6 et les creusets 18, il est prévu :
- un chambre d'injection 41, dans laquelle débouchent lesdites aiguilles d'injection 5 et 6 ;
- une chambre de mélange 43, dans laquelle débouche l'aiguille d'évacuation 7 (par l'intermédiaire de l'élément tubulaire 40) ;
- une élément de diffusion ou de rétention 42 ou 45, éventuellement associé à un obturateur commandable complémentaire 46 à 49 ;
- une chambre intermédiaire 44, séparée da ladite chambre de mélange 43 par ledit élément de diffusion ou de rétention 42 ou 45 ; et
- un obturateur commandable principal 21, disposé entre ladite chambre intermédiaire 44 et lesdits creusets 18.

## Revendications

1. Système de cristallogénèse par diffusion, notamment destiné à être mis en oeuvre à bord d'un vaisseau spatial, dans lequel une substance à cristalliser est mise en présence d'un agent précipitant, du type comportant :
- au moins une capsule (17) enfermant au moins un creuset (18) et remplie d'agent précipitant, ledit creuset contenant ladite substance à cristalliser, et
- au moins un réceptacle (4) en communication avec des moyens d'amenée d'agent précipitant (2,3,8,9,10,11) et des moyens d'évacuation d'agent précipitant (12,13),
caractérisé en ce que ladite capsule (17) est étanche, et en ce que sont prévus des moyens de connexion (5,6,7,23) permettant automatiquement de relier de manière étanche et directe l'intérieur de ladite capsule (17) avec lesdits moyens d'amenée (2,3,8,9,10,11) et avec lesdits moyens d'évacuation (12,13) d'agent précipitant, lors de l'introduction de ladite capsule étanche (17) dans ledit réceptacle.

2. Système de cristallogénèse selon la revendication 1,
caractérisé en ce que lesdits moyens de connexion (5,6,7,23) comportent, d'une part, des aiguilles (5,6,7) liées audit réceptacle (4) et, d'autre part, des blocs (23) d'une matière susceptible d'être perforée de manière étanche par lesdites aiguilles, lesdits blocs étant liés à ladite capsule (17).

3. Système de cristallogénèse selon l'une des revendications 1 ou 2,
caractérisé en ce que lesdits moyens d'amenée d'agent précipitant comportent au moins une seringue (2,3).

4. Système de cristallogénèse selon l'une quelconque des revendications 2 ou 3,
caractérisé en ce qu'il comporte un bouchon (14) pouvant être introduit dans ledit réceptacle (4) à la place de ladite capsule (17), ledit bouchon (14) comportant un corps spongieux (15) imbibé d'agent précipitant et accessible auxdites aiguilles (5,6,7) desdits moyens de connexion à travers des blocs (16) solidaires dudit bouchon et réalisés en une matière susceptible d'être perforée de manière étanche par lesdites aiguilles.

5. Système de cristallogénèse selon l'une quelconque des revendications 1 à 4,
caractérisé en ce que des clapets anti-retour (10,11) sont prévus dans lesdits moyens d'amenée d'agent précipitant.

6. Système de cristallogénèse selon l'une quelconque des revendications 1 à 5,
caractérisé en ce que lesdits moyens d'évacuation d'agent précipitant comportent un vase d'expansion (12).

7. Système de cristallogénèse selon l'une quelconque des revendications 1 à 6,
caractérisé en ce qu'un premier obturateur commandable (21) est prévu à l'intérieur de ladite capsule (17), afin soit d'obturer ledit creuset pour isoler son contenu de la cavité intérieure de ladite capsule, soit de dégager ledit creuset pour mettre son contenu en communication avec cette dernière cavité.

8. Système de cristallogénèse selon la revendication 7,
caractérisé en ce que ledit premier obturateur commandable (21) est un disque ajouré monté rotatif autour d'un arbre (28) accessible de l'extérieur de ladite capsule.

9. Système de cristallogénèse selon la revendication 8,
caractérisé en ce que l'arbre (18) dudit disque rotatif (21) peut coulisser de façon limitée, parallèlement à son axe, de façon que ledit disque soit écarté du creuset pendant le passage du disque d'une position d'obturation à une position de dégagement et vice-versa.

10. Système de cristallogénèse selon l'une quelconque des revendications 7 à 9,
caractérisé en ce que au moins la partie du premier obturateur (21) entrant en contact avec le creuset dans une position d'obturation est constituée par une membrane souple (34).

11. Système de cristallogénèse selon l'une quelconque des revendications 1 à 10,
caractérisé en ce qu'une paroi de séparation (38,39) est prévue, à l'intérieur de ladite capsule, entre lesdits moyens de connexion (5,6) correspondant auxdits moyens d'amenée d'agent précipitant et lesdits moyens de connexion (7) correspondant auxdits moyens d'évacuation d'agent précipitant.

12. Système de cristallogénèse selon l'une quelconque des revendications 1 à 11,
caractérisé en ce qu'une surface de diffusion (42) est prévue, à l'intérieur de ladite capsule, entre, d'une part, lesdits moyens de connexion (5,6,7) auxdits moyens d'amenée et d'évacuation d'agent précipitant et, d'autre part, ledit creuset (18).

13. Système de cristallogénèse selon l'une quelconque des revendications 1 à 11, destiné à la diffusion en phase vapeur,
caractérisé en ce qu'un élément de rétention d'agent précipitant (45) est prévu, à l'intérieur de ladite capsule, entre, d'une part, lesdits moyens de connexion (5,6,7) auxdits moyens d'amenée et d'évacuation d'agent précipitant et, d'autre part, ledit creuset (18).

14. Système de cristallogénèse selon la revendication 13,
caractérisé en ce qu'un second obturateur commandable (46,49) est associé audit élément de rétention (45).

15. Système de cristallogénèse selon la revendication 12,
caractérisé en ce qu'une chambre intermédiaire (44) est prévue entre ladite surface de diffusion (42) et ledit premier obturateur commandable (21).

16. Système de cristallogénèse selon l'une ou l'autre des revendications 13 ou 14,
caractérisé en ce qu'une chambre intermédiaire (44) est prévue entre ledit élément de rétention (45) ou ledit second obturateur (46,49) respectivement, et ledit premier obturateur commandable (21).

17. Système de cristallogénèse selon la revendication 14,
caractérisé en ce que lesdits premier et second obturateurs commandables sont couplés en rotation.

18. Système de cristallogénèse selon l'une quelconque des revendications 1 à 13,
caractérisé en ce que ladite capsule et ledit réceptacle comportent des moyens d'indexage et/ou de détrompage coopérants.

## Claims

1. System for crystal generation by diffusion, intended especially to be used aboard a spacecraft, in which a substance to be crystallised is placed in the presence of a precipitating agent, of the type comprising:
- at least one capsule (17) containing at least one crucible (18) and filled with precipitating agent, the said crucible containing the said substance to be crystallised, and
- at least one receptacle (4) in communication with means for delivery of precipitating agent (2, 3, 8, 9, 10, 11) and means for removal of precipitating agent (12, 13),
characterised in that the said capsule (17) is leakproof, and in that coupling means (5, 6, 7, 23) are provided allowing the interior of the said capsule (17) to be automatically connected in a leakproof and direct manner to the said means for delivery (2, 3, 8, 9, 10, 11) and to the said means for removal (12, 13) of precipitating agent during the introduction of the said leakproof capsule (17) into the said receptacle.

2. System for crystal generation according to Claim 1, characterised in that the said coupling means (5, 6, 7, 23) comprise, on the one hand, needles (5, 6, 7) connected to the said receptacle (4) and, on the other hand, blocks (23) of a material capable of being perforated in a leakproof manner by the said needles, the said blocks being connected to the said capsule (17).

3. System for crystal generation according to either of Claims 1 and 2, characterised in that the said means for delivery of precipitating agent comprise at least one syringe (2, 3).

4. System for crystal generation according to either of Claims 2 and 3, characterised in that it comprises a plug (14) which can be introduced into the said receptacle (4) instead of the said capsule (17), the said plug (14) comprising a spongy body (15) saturated with precipitating agent and accessible to the said needles (5, 6, 7) of the said coupling means through blocks (16) which are integrally attached to the said plug and are made of a material capable of being perforated in a leakproof manner by the said needles.

5. System for crystal generation according to any one of Claims 1 to 4, characterised in that nonreturn valves (10, 11) are provided in the said means for delivery of precipitating agent.

6. System for crystal generation according to any one of Claims 1 to 5, characterised in that the said means for removal of precipitating agent comprise an expansion vessel (12).

7. System for crystal generation according to any one of Claims 1 to 6, characterised in that a first controllable shutter (21) is provided inside the said capsule (17), in order either to close the said crucible to isolate its contents from the internal cavity of the said capsule or to open the said crucible to place its contents in communication with this latter cavity.

8. System for crystal generation according to Claim 7, characterised in that the said first controllable shutter (21) is a perforated disc mounted rotatably around a shaft (28) accessible from the outside of the said capsule.

9. System for crystal generation according to Claim 8, characterised in that the shaft (18) of the said rotary disc (21) can slide in a limited manner, in parallel with its axis, so that the said disc is moved away from the crucible during the switching of the disc from a closed position to an open position and vice versa.

10. System for crystal generation according to any one of Claims 7 to 9, characterised in that at least the part of the first shutter (21) which comes into contact with the crucible in a closed position consists of a flexible membrane (34).

11. System for crystal generation according to any one of Claims 1 to 10, characterised in that a separating wall (38, 39) is provided inside the said capsule between the said coupling means (5, 6) corresponding to the said means for delivery of precipitating agent and the said coupling means (7) corresponding to the said means for removal of precipitating agent.

12. System for crystal generation according to any one of Claims 1 to 11, characterised in that a diffusion surface (42) is provided inside the said capsule between, on the one hand, the said means of coupling (5, 6, 7) to the said means for delivery and for removal of precipitating agent and, on the other hand, the said crucible (18).

13. System for crystal generation according to any one of Claims 1 to 11, intended for diffusion in vapour phase, characterised in that a member for retaining precipitating agent (45) is provided inside the said capsule between, on the one hand, the said means for coupling (5, 6, 7) to the said means for delivery and for removal of precipitating agent and, on the other hand, the said crucible (18).

14. System for crystal generation according to Claim 13, characterised in that a second controllable shutter (46, 49) is used in combination with the said retaining member (45).

15. System for crystal generation according to Claim 12, characterised in that an intermediate chamber (44) is provided between the said diffusion surface (42) and the said first controllable shutter (21).

16. System for crystal generation according to either of Claims 13 and 14, characterised in that an intermediate chamber (44) is provided between the said retaining member (45) or the said second shutter (46, 49) respectively and the said first controllable shutter (21).

17. System for crystal generation according to Claim 14, characterised in that the said first and second controllable shutters are coupled in rotation.

18. System for crystal generation according to any one of Claims 1 to 13, characterised in that the said capsule and the said receptacle comprise interacting register and/or foolproofing means.

## Patentansprüche

1. System zur Kristallerzeugung durch Streuung, insbesondere zur Benutzung an Bord eines Raumschiffes, in welchem eine zu kristallisierende Substanz mit einem Abscheidungsmittel in Verbindung gebracht wird, das
- aus mindestens einer Kapsel (17) besteht, die mindestens einen Tiegel (18) enthalt und mit einem Abscheidungsmittel gefüllt ist, wobei der Tiegel die genannte zu kristallisierende Substanz enthält,
sowie
- aus mindestens einem Auffang (4), der mit Zuführungsmittel für Abscheidungsmittel (2, 3, 8, 9, 10, 11) und Ablaufmittel für Abscheidungsmittel (12, 13) verbunden ist,
dadurch gekennzeichnet,
daß genannte Kapsel (17) dicht ist, und daß Anschlußmittel (5, 6, 7, 23) vorgesehen sind, welche es gestatten, das Innere genannter Kapsel (17) abgedichtet und direkt mit den genannten Zuführungsmitteln (2, 3, 8, 9, 10, 11) und mit dem genannten Ablaufmittel (12, 13) für Abscheidungsmittel, bei der Einführung genannter dichten Kapsel (17) in den genannten Auffang, zu verbinden.

2. System zur Kristallerzeugung gemäß Anspruch 1,
dadurch gekennzeichnet,
daß genannte Anschlußmittel (5, 6, 7, 23) einerseits mit genanntem Auffang (4) verbundene Nadeln (5, 6, 7) enthält und andererseits Blöcke (23) aus einem Material, daß von den genannten Nadeln dicht durchbohrt werden kann, wobei genannte Blöcke mit genannter Kapsel (17) verbunden sind.

3. System zur Kristallerzeugung gemäß einem der Ansprüche 1 oder 2,
dadurch gekennzeichnet,
daß die Zuführungsmittel für das Abscheidungsmittel mindestens eine Spitze (2, 3) enthalten.

4. System zur Kristallerzeugung nach irgend einem der Ansprüche 2 oder 3,
dadurch gekennzeichnet,
daß es einen Pfropfen (14) enthält, der in genanntem Aufang (4) an Stelle der genannten Kapsel (17) eingesteckt werden kann, wobei genannter Pfropfen (14) aus einem schwammigen mit Abscheidungsmittel getränkten und für genannte Nadeln (5, 6, 7) der genannten Anschlußmittel durch Blöcke (16) des genannten Pfropfens hindurch zugänglichen Körper (15) besteht, die mit dem genannten Pfropfen fest verbunden sind und aus einem Material, das durch die Nadeln abgedichtet durchbohrt werden kann, hergestellt sind.

5. System zur Kristallerzeugung nach irgend einem der Ansprüche 1 bis 4,
dadurch gekennzeichnet,
daß im genannten Zuführungsmittel für das Abscheidungsmittel Rückschlagventile (10, 11) vorgesehen sind.

6. System zur Kristallerzeugung nach irgend einem der Ansprüche 1 bis 5,
dadurch gekennzeichnet,
daß genannte Ablaufmittel für das Abscheidungsmittel ein Ausdehnungsgefäß (12) enthalten.

7. System zur Kristallerzeugung nach irgend einem der Ansprüche 1 bis 6,
dadurch gekennzeichnet,
daß ein erster steuerbarer Verschluß (21) im Innern genannter Kapsel (17) vorgesehen ist, um entweder besagten Tiegel zu verschließen, um seinen Inhalt vom inneren Hohlraum der genannten Kapsel zu isolieren, oder den besagten Tiegel zu öffnen, damit sein Inhalt mit diesem Hohlraum kommunizieren kann.

8. System zur Kristallerzeugung gemäß Anspruch 7,
dadurch gekennzeichnet,
daß dieser erste steuerbare Verschluß (21) eine durchbrochene Scheibe ist, die um eine von außen der genannten Kapsel zugänglichen Well (28) drehbar angeordnet ist.

9. System zur Kristallerzeugung gemäß Anspruch 8,
dadurch gekennzeichnet,
daß die Welle (18) der drehbaren Scheibe (21) begrenzt und parallel zur Achse verschiebbar ist, so daß genannte Scheibe beim Wechsel der Scheibe von einer Verschlußstellung zu einer Freistellung und umgekehrt vom Tiegel entfernt ist.

10. System zur Kristallerzeugung gemäß einem der Ansprüche 7 bis 9,
dadurch gekennzeichnet,
daß mindestens der Teil des ersten Verschlusses (21), welcher mit dem Tiegel in einer Verschlußstellung in Kontakt kommt, aus einer weichelastischen Membrane (34) besteht.

11. System zur Kristallerzeugung gemäß irgend einem der Ansprüche 1 bis 10,
dadurch gekennzeichnet,
daß im Innen genannter Kapsel zwischen den genannten Anschlußmitteln (5, 6), die den Zuführungsmitteln für das Abscheidungsmittel entsprechen und den Anschlußmitteln (7), die dem genannten Ablaufmittel entsprechen, sich eine Trennungswand (38, 39) befindet.

12. System zur Kristallerzeugung gemäß irgend einem der Ansprüche 1 bis 11,
dadurch gekennzeichnet,
daß im Innern genannter Kapsel zwischen einerseits den genannten Anschlußmitteln (5, 6, 7) der Zuführungs- und Ablaufmittel des Abscheidungsmittels und andererseits dem genannten Tiegel (18) eine Diffusionsfläche (42) vorgesehen ist.

13. System zur Kristallerzeugung gemäß irgend einem der Ansprüche 1 bis 11, das zur Dissusion in Dampf phase bestimmt ist,
dadurch gekennzeichnet,
daß im Innern der Kapsel ein Retentionselement des Abscheidungsmittels (45) vorgesehen ist zwischen einerseits den genannten Anschlußmitteln (5, 6, 7) an die Zuführungs- und Ablaufmittel des Abscheidungsmittels und andererseits dem Tiegel (18).

14. System zur Kristallerzeugung gemäß Anspruch 13,
dadurch gekennzeichnet,
daß ein zweiter steuerbarer Verschluß (46, 49) mit dem genannten Retentionselement (45) verbunden ist.

15. System zur Kristallerzeugung gemäß Anspruch 12,
dadurch gekennzeichnet,
daß eine Zwischenkammer (44) zwischen genannter Diffusionsfläche (42) und genanntem ersten steueubaren Verschluß (21) vorgesehen ist.

16. System zur Kristallerzeugung gemäß einem der Ansprüche 13 oder 14,
dadurch gekennzeichnet,
daß eine Zwischenkammer (44) zwischen dem genannten Retentionselement (45) oder dem genannten zweiten Verschluß (46, 49) und dem ersten steuerbaren Verschluß (21) vorgesehen ist.

17. System zur Kristallerzeugung gemäß Anspruch 14,
dadurch gekennzeichnet,
daß genannter erster und zweiter steuerbarer Verschluß in Rotation gekuppelt sind.

18. System zur Kristallerzeugung gemäß irgendeinem der Ansprüche 1 bis 13,
dadurch gekennzeichnet,
daß genannte Kapsel und genannter Auffang kooperierende Indexierungs- und/oder Unverwechselbarkeitsmittel enthalten.
